# EUROPÄISCHE PATENTSCHRIFT

(11) **EP 2 486 172 B1**
(45) Veröffentlichungstag und Bekanntmachung des Hinweises auf die Patenterteilung: **05.04.2017**
(21) Anmeldenummer: 10757110.1
(22) Anmeldetag: 27.09.2010
(51) Int. Cl.: H01L 21/67, C25D 7/12, C25D 21/18, C25D 21/20, C25D 21/08, C25D 17/00, H01L 21/762, H01L 21/677

(54) **VERFAHREN UND ANLAGE ZUR HERSTELLUNG METALLISIERTER HALBLEITERSUBSTRATE**
METHOD AND INSTALLATION FOR PRODUCING METALLISED SEMICONDUCTOR SUBSTRATES
PROCÉDÉ ET INSTALLATION POUR PRODUIRE DES SUBSTRATS SEMI-CONDUCTEURS MÉTALLISÉS

(30) Priorität: 09.10.2009 DE 102009049565
(43) Veröffentlichungstag der Anmeldung: 15.08.2012
(73) Patentinhaber: Gebr. Schmid GmbH & Co., 72250 Freudenstadt (DE)
(72) Erfinder: SCHMID, Christian, 72250 Freudenstadt (DE); KAPPLER, Heinz, 72280 Dornstetten-Aach (DE); HABERMANN, Dirk, 79199 Kirchzarten (DE)
(74) Vertreter: Patentanwälte Ruff, Wilhelm, Beier, Dauster & Partner mbB
(86) Internationale Anmeldenummer: PCT/EP2010/064237
(87) Internationale Veröffentlichungsnummer: WO 2011/042324

(56) Entgegenhaltungen:
- WO-A1-2009/012891
- WO-A1-2009/015886
- GB-A- 2 001 101
- US-A- 3 640 331
- US-A- 4 611 409
- US-A- 4 790 904

## Beschreibung

Die vorliegende Erfindung betrifft ein mehrstufiges Verfahren zur Herstellung von metallisierten Halbleitersubstraten, insbesondere von metallisierten Wafern aus Silizium, und eine dafür geeignete Anlage.

Ein bekanntes Beispiel für die Herstellung metallisierter Halbleitersub-strate ist die Metallisierung von Wafern, worunter man das Aufbringen von stromabführenden elektrisch leitenden Kontakten auf deren Vorder- und/oder Rückseite versteht, z.B. im Rahmen eines Verfahrens zur Herstellung von Solarzellen. Die Kontakte müssen zum einen eine gute mechanische und elektrische Anbindung an den Wafer aufweisen und weiterhin eine hohe elektrische Eigenleitfähigkeit und/oder einen ausreichend hohen Leiterbahnquerschnitt. Während diesen Anforderungen bei der Metallisierung von Solarzellenrückseiten leicht genügt werden kann ist die Metallisierung der Vorder- bzw. Lichteinfallsseite der Solarzelle diesbezüglich häufig problematisch. Während Solarzellenrückseiten nämlich in der Regel mit einer durchgehenden Ableiterschicht versehen werden, ist es zweckmäßig, auf der Lichteinfallsseite die Ableiterstrukturen so dünn wie möglich zu halten, damit viel Oberfläche zum Einfangen von Photonen bzw. Licht zur Verfügung steht. Solch dünne Strukturen bieten jedoch naturgemäß einen geringen Leiterbahnquerschnitt und weisen damit einen vergleichsweise hohen ohmschen Widerstand auf. Zusätzlich können Probleme mit der Haftung zur Waferoberfläche auftreten.

Üblicherweise werden derartige Strukturen in Dickfilmtechniken wie zum Beispiel durch Sieb-, Schablonen- oder Tampondruck aufgebracht. Die dabei erhaltenen Leiterstrukturen können gegebenenfalls noch photoinduziert und stromlos nachverstärkt werden, wie dies zum Beispiel aus der DE 43 33 426 A1 bekannt ist.

Ein weiteres bekanntes Beispiel für die Herstellung metallisierter Halbleitersubstrate ist die Abscheidung von CIGS-Schichten (CIGS steht für Cu(In,Ga)(S,Se)₂, also die verwendeten Elemente Kupfer, Indium, Gallium, Schwefel und Selen) bei der Herstellung von Dünnschichtsolarzellen. Die wichtigsten Beispiele für CIGS-Schichten sind Schichten aus Cu(In,Ga)Se₂ (Kupfer-Indium-Gallium-Diselenid) oder CuInS₂ (Kupfer-Indium-Disulfid). Alternativ zu CIGS-Schichten können auch Schichten aus Kesterit (Cu₂ZnSnS₄) als photovoltaische Absorberschichten abgeschieden werden. Zur Herstellung von Dünnschichtsolarzellen wird auf einem Substrat ein elektrisch leitender Rückkontakt gebildet, beispielsweise aus Molybdän, auf das anschließend die CIGS-Schicht oder die Kesteritschicht abgeschieden wird. Auf dieser wird ein elektrisch leitender Frontkontakt gebildet, beispielsweise aus mit Aluminium dotiertem Zinkoxid. Die Abscheidung dieser Schichten kann sowohl aus der Gasphase erfolgen (beispielsweise durch Sputtern oder ein CVD- oder PVD-Verfahren) als auch aus einem Elektrolyten, also insbesondere auch galvanisch.

Gemein ist allen Verfahren zur Herstellung metallisierter Halbleitersubstrate , dass sie unter Entsorgungsgesichtspunkten relativ problematisch sind. Bei der Herstellung fallen stets erhebliche Mengen an Metallabfällen an, insbesondere bei Verfahren, in denen metallionenhaltige Elektrolyten zum Einsatz kommen.

Aus der US 4,790,904 ist ein Verfahren zum Metallisieren von Arbeitssubstraten bekannt, bei welchem das zu metallisierende Arbeitssubstrat zunächst in ein Beschichtungsbad überführt und anschließend einer mehrstufigen Spülung unterworfen wird.

Der vorliegenden Erfindung lag die Aufgabe zugrunde, eine verbesserte technische Lösung zur Herstellung metallisierter Halbleitersubstrate bereitzustellen, bei der die genannten Probleme vermieden werden oder nur in verringertem Maß auftreten.

Diese Aufgabe wird gelöst durch das Verfahren mit den Merkmalen des Anspruchs 1 und die Anlage mit den Merkmalen des Anspruchs 9. Bevorzugte Ausführungsformen des erfindungsgemäßen Verfahrens finden sich in den abhängigen Ansprüchen 2 bis 8. Bevorzugte Ausführungsformen der erfindungsgemäßen Anlage sind in den abhängigen Ansprüchen 10 und 11 angegeben. Einige der im Folgenden beschriebenen Merkmale lassen sich sowohl dem erfindungsgemäßen Verfahren als auch der erfindungsgemäßen Anlage zuordnen, werden aber zur Vermeidung von Wiederholungen nur im Zusammenhang mit einem der erfindungsgemäßen Gegenstände erwähnt. Ungeachtet dessen sollen sie fakultativ auch den jeweils anderen erfindungsgemäßen Gegenstand charakterisieren können. Der Wortlaut sämtlicher Ansprüche wird hiermit durch Bezugnahme zum Inhalt dieser Beschreibung gemacht.

Ein erfindungsgemäßes Verfahren dient zur Herstellung metallisierter Halbleitersubstrate und weist stets zumindest drei Schritte auf, nämlich
(1) das Eintauchen eines Substrats, in ein einen Elektrolyten enthaltendes Beschichtungsbad,
(2) das Beschichten, insbesondere das lichtinduzierte oder lichtunterstützte Beschichten, der Oberfläche des eingetauchten Substrats und
(3) das Überführen des Substrats in eine Spüleinrichtung, in der die beschichtete Oberfläche mit Hilfe eines Spülmediums weitestgehend von Metallrückständen aus dem Elektrolyten befreit wird.

Jeder dieser drei Schritte ist für sich gesehen bereits aus dem Stand der Technik bekannt. So ist z.B. ein Eintauchen eines Wafers in ein Elektrolysebad zwecks lichtinduzierter oder lichtunterstützter Beschichtung seiner Oberfläche beispielsweise aus der noch DE 10 2009 022 337.1 oder der DE 10 2007 038 120.6 der Anmelderin bekannt. Ferner kann diesbezüglich auch auf die bereits eingangs erwähnte DE 43 33 426 A1 Bezug genommen werden.

Bei den herzustellenden Halbleitersubstraten handelt es sich insbesondere um metallisierte Wafer, insbesondere solche aus Silizium, und um Dünnschichtsolarzellen auf CIGS-Basis, wie sie jeweils eingangs beschrieben wurden. Bei den verwendeten Substraten handelt es sich entsprechend um Halbleitersubstrate wie Silizium-Wafer (sowohl in unprozessierter Form als auch in prozessierter Form, also in Form einer bereits funktionsfähigen Zelle) oder CIGS-Schichten, die im Rahmen des vorliegenden Verfahrens mit stromabführenden elektrisch leitenden Kontakten versehen werden, oder um solche elektrisch leitende Kontakte, auf die Halbleiterschichten aufgebracht werden. Ein Beispiel für letztere Variante ist das eingangs erwähnte Aufbringen von halbleitenden CIGS-oder Kesteritschichten auf einen elektrisch leitenden Rückkontakt. Als Substrat dient in diesem Fall also der Rückkontakt. Unter dem erwähnten Beschichten der Oberfläche des eingetauchten Substrats ist entsprechend insbesondere das Aufbringen metallischer Strukturen auf die Oberfläche eines Halbleitersubstrats oder das Aufbringen halbleitender Strukturen auf die Oberfläche eines metallischen Substrats zu verstehen.

Im Gegensatz zu den zum Stand der Technik gehörigen Vorgehensweisen zeichnet sich das erfindungsgemäße Verfahren insbesondere dadurch aus, dass das Beschichtungsbad zumindest zum Teil mit in der Spüleinrichtung anfallendem metallhaltigem Spülmedium gespeist wird. Metallhaltiges Spülmedium aus der Spüleinrichtung wird also in das Beschichtungsbad überführt und ersetzt dort zumindest teilweise Elektrolyten, der beispielsweise mit den beschichteten Substraten aus dem Bad ausgetragen wurde oder z.B. durch Verdampfung entwichen ist. Nach dem Beschichten der Oberfläche des Substrats bleiben nämlich auf der Oberfläche stets Elektrolytrückstände haften, die anschließend entfernt werden müssen. Dies geschieht erfindungsgemäß in der Spüleinrichtung unter Anfall des erwähnten metallhaltigen Spülmediums.

Da Standardelektrolyten zahlreiche umweltschädliche Stoffe, insbesondere metallischer Art, enthalten, war die notwendige Entsorgung des Spülmediums bislang entsprechend aufwendig und teuer. Darüber hinaus musste aus dem Beschichtungsbad ausgeschleppter Elektrolyt permanent ersetzt werden, womit zusätzliche Kosten generiert wurden. Das erfindungsgemäße Verfahren setzt dem ein Ende. Hierdurch wird nämlich eine Kreislaufführung etabliert, in deren Folge nahezu kein metallhaltiges Spülmedium mehr entsorgt werden muss und stattdessen ausgeschleppter Elektrolyt durch das metallhaltige Spülmedium zumindest teilweise ersetzt wird. Somit kann das erfindungsgemäße Verfahren auch deutlich wirtschaftlicher betrieben werden als klassische Verfahren ohne solche Kreislaufführung. Insbesondere die im ausgeschleppten Elektrolyten enthaltenen wertvollen Metalle gehen nämlich nicht verloren, sondern können so wiederverwertet werden.

In bevorzugten Ausführungsformen des erfindungsgemäßen Verfahrens wird in der Spüleinrichtung anfallendes metallhaltiges Spülmedium vollständig in das Beschichtungsbad überführt. Darunter soll verstanden werden, dass kein Spülmedium verworfen wird, das metallhaltige Spülmedium wird vollständig wieder- bzw. weiterverwertet.

In besonders bevorzugten Ausführungsformen kann das metallhaltige Spülmedium vor Einleitung in das Beschichtungsbad aufkonzentriert werden. Dies kann beispielsweise dadurch geschehen, dass das Spülmedium teilweise verdampft wird, z.B. bis die Konzentration an Metall bzw. an Metallverbindungen im Spülmedium zumindest ungefähr der Konzentration an Metall im Elektrolyten des Beschichtungsbades entspricht. Alternativ oder zusätzlich kann dem metallhaltigen Spülmedium natürlich auch eine entsprechende Menge an einer oder mehreren Metallverbindungen, insbesondere mindestens ein Metallsalz, zugegeben werden. Dadurch können auch die durch Abscheidung auf den Substraten verursachten Verluste an Metallionen ausgeglichen werden.

Eine alternative oder zusätzliche Möglichkeit, die Konzentration an Metallionen im Elektrolyten zu kontrollieren oder zu steuern, besteht im kombinierten Einsatz von löslichen und unlöslichen Elektroden. So kann das verwendete Beschichtungsbad beispielsweise eine Anzahl von Verbrauchselektroden aufweisen, die im Betrieb die Metallkonzentration im Bad aufrecht erhalten. Werden nun mit rückgeführtem Spülmedium zusätzliche Metallionen in den Elektrolyten eingetragen, so kann die Konzentration an Metall im Bad unter Umständen unerwünscht stark ansteigen. Um eine solche unerwünschte Aufkonzentration an Metallionen zu verhindern, können eine oder mehrere, ggf. auch alle Verbrauchselektroden durch Zuschalten von einer oder mehrerer der erwähnten unlöslichen Elektroden ersetzt werden, bis die Badkonzentration wieder die gewünschten Werte erreicht hat.

Die Metallkonzentration im Elektrolyten und im rückgeführten Spülmedium kann beispielsweise über Sensoren oder durch chemische Analyse kontinuierlich überwacht werden. In Abhängigkeit der Überwachungsergebnisse kann dann die Zuschaltung der unlöslichen Elektroden und/oder die Aufkonzentrierung des metallhaltigen Spülmediums erfolgen.

Besonders bevorzugt wird die Menge an rückgeführtem Spülmedium und/oder die Menge der einen oder der mehreren Metallverbindungen, die dem Spülmedium vor Einspeisung in das Beschichtungsbad gegebenenfalls zugesetzt werden, gezielt auf den kontinuierlichen Elektrolytverlust abgestimmt, so dass der Elektrolytaustrag aus dem Beschichtungsbad vollständig durch das rückgeführte Spülmedium kompensiert werden kann. Gegebenenfalls muss die Menge des rückgeführten Spülmediums durch Verdampfung angepasst werden. Es ist aber natürlich auch möglich, den Elektrolytverlust teilweise durch das rückgeführte Spülmedium und teilweise durch Zuführung von frischem Elektrolyten zu kompensieren.

Bei dem Elektrolyten handelt es sich vorzugsweise um einen Elektrolyten, der mindestens ein Metall aus der Gruppe mit Silber, Kupfer, Nickel, Zink und Zinn umfasst. Besonders bevorzugt sind silberhaltige Elektrolyten. Alternativ können auch Indium-, Gallium- und/oder Selen-haltige Elektrolyten zum Einsatz kommen, nämlich insbesondere wenn im Rahmen des erfindungsgemäßen Verfahrens CIGS-Schichten galvanisch abgeschieden werden sollen. Die Metalle sind in dem Elektrolyten dabei in aller Regel in ionischer und somit in gelöster Form enthalten und/oder in Form von suspendierten Metallverbindungen. Als Lösungsmittel kommt vorzugsweise Wasser zum Einsatz. Der verwendete Elektrolyt ist also in der Regel ein wässriger Elektrolyt.

Beim Spülmedium handelt es sich besonders bevorzugt um eine wässrige Lösung. Da das Spülmedium ja Verwendung als Elektrolyt findet, sollte es zum Elektrolyten im Beschichtungsbad chemisch kompatibel sein.

Neben den Metallen kann der Elektrolyt auch Zusätze enthalten, beispielsweise eine oder mehrere Säuren wie Schwefel-, Salzsäure und/oder eine oder mehrere organische Säuren. Auch diverse organische Zusätze, die die Eigenschaften des Elektrolyten im Hinblick auf die Qualität der abzuscheidenden Metallschicht sowie im Hinblick auf seine chemische Beständigkeit verbessern sollen, sind durchaus üblich.

Entsprechend kann es bevorzugt sein, dass dem metallhaltigen Spülmedium derartige Additive zugesetzt werden, bevor es in das Beschichtungsbad eingespeist wird. Dies kann insbesondere auch beim oder nach dem Aufkonzentrieren des metallhaltigen Spülmediums geschehen.

In besonders bevorzugten Ausführungsformen des erfindungsgemäßen Verfahrens enthält das in der Spüleinrichtung verwendete Spülmedium bereits eines oder mehrere solcher Additive. So kann die Oberfläche der Substrate in der Spüleinrichtung z.B. mit einer säurehaltigen wässrigen Lösung gereinigt werden. Das Spülmedium kann bevorzugt die gleiche chemische Zusammensetzung wie der Elektrolyt aufweisen, abgesehen davon, dass es keines der in dem Beschichtungsbad abzuscheidenden Metalle enthält.

In der Spüleinrichtung wird das Substrat einer Kaskadenspülung unterzogen. Unter einer Kaskadenspülung soll vorliegend verstanden werden, dass das Spülen des Substrats nicht nur in einer Spülstation sondern stattdessen in mindestens zwei in Serie geschalteten Spülstationen erfolgt. Das zu spülende Substrat wird zunächst in eine erste Spülstation, beispielsweise eine erste Spülwanne, und danach in mindestens eine weitere Spülstation, beispielsweise eine weitere Wanne, überführt. In der ersten und der mindestens einen weiteren Spülstation erfolgt jeweils ein Spülen des Substrats mit dem flüssigen Spülmedium. Der Großteil der auf der Oberfläche des Substrat befindlichen Metallrückstände aus dem Elektrolyten wird dabei bereits in der ersten Spülstation durch das Spülmedium vom Substrat abgetragen. Das Spülmedium in einer zweiten Spülstation wird somit nicht mehr so stark verunreinigt wie das in der ersten. Je mehr Spülstationen ein Substrat hintereinander durchläuft, desto weniger ist das Spülmedium in der jeweils letzten Station durch Metallrückstände belastet. Frisches Spülmedium wird dabei bevorzugt nicht etwa allen Stationen einer Spüleinrichtung zugeführt, sondern insbesondere nur der jeweils letzten. Von dort fließt das Spülmedium entgegen der Transportrichtung der zu spülenden Substrate bis in die erste Station. Umfasst eine Spüleinrichtung also beispielsweise drei Spülstationen, so wird das Substrat in der letzten Spülstation, die es durchläuft, bevorzugt mit frischem Spülmedium gespült, in der mittleren bevorzugt mit in der letzten Spülstation verwendetem und in der ersten mit in der mittleren verwendetem Spülmedium. Aus dieser ersten Spülstation wird das verbrauchte Spülmedium dann abgeführt und erfindungsgemäß seiner Wiederverwertung im Beschichtungsbad zugeführt.

Der Effekt einer solchen Kaskadenspülung ist simpel aber effizient. Es wird gewährleistet, dass sich in der letzten Station das am wenigsten verunreinigte Spülmedium befindet und der Grad der Verunreinigung kontinuierlich in Richtung der ersten Station ansteigt. Die so betriebene Mehrfachnutzung des Spülmediums senkt den Gesamtverbrauch an Spülmedium drastisch. Darüber hinaus sind die erwähnten Metallrückstände in der ersten Spülstation maximal angereichert, so dass gegebenenfalls der Aufwand zur Aufkonzentrierung des Spülmediums vor Wiedereinspeisung in das Beschichtungsbad vergleichsweise gering ausfällt.

In bevorzugten Ausführungsformen umfasst das erfindungsgemäße Verfahren neben den bereits erwähnten Schritten noch mindestens einen mechanischen Reinigungsschritt, bei dem Elektrolytrückstände von der Oberfläche des Substrats entfernt werden. Diese mechanische Entfernung von Elektrolytrückständen erfolgt vorzugsweise bevor das Substrat in die Spüleinrichtung überführt wird.

Hierzu können beispielsweise Quetschwalzen installiert werden, mittels denen Elektrolyt von der Oberfläche des Substrats abgestreift werden kann. Alternativ oder zusätzlich können Elektrolytrückstände von der Oberfläche des Substrats auch durch Luftspülung, also insbesondere mit Druckluft, entfernt werden. Hierzu können beispielsweise Abblasdüsen zwischen dem Beschichtungsbad und der Spüleinrichtung installiert werden.

Bevorzugt wird der mechanisch von der Oberfläche des Substrats entfernte Elektrolyt wie das Spülmedium wiederverwertet. Er kann z.B. unmittelbar wieder in das Beschichtungsbad überführt werden. Alternativ kann er z.B. aber auch zur Aufkonzentrierung des metallhaltigen Spülmediums dienen.

Die Rückführung des metallhaltigen Spülmediums aus der Spüleinrichtung erfolgt nicht unmittelbar zurück in das Beschichtungsbad auch auf dem Umweg über eine Abblaszone bzw. ein Luftbad, in dem die erwähnte Entfernung der Elektrolytrückstände von der Oberfläche des Substrats durch Luftspülung erfolgt. Hierzu kann eine eigene Rückführungsleitung vorgesehen sein. Das verbrauchte Spülmedium kann in der Abblaszone versprüht werden und dampft dabei ein. Dieses Verfahren erlaubt die Aufkonzentration von Elektrolyten im Spülwasser ohne Installation zusätzlicher Heizeinrichtungen.

Eine erfindungsgemäße Anlage zur Herstellung metallisierter Halbleitersubstrate, insbesondere von metallisierten Wafern aus Silizium, umfasst zumindest ein Beschichtungsbad mit einem Elektrolyten zum vorzugsweise lichtinduzierten oder lichtunterstützten Beschichten der Oberfläche eines in das Bad eingetauchten Substrats, eine Spüleinrichtung, in der die beschichtete Oberfläche des Substrats mit Hilfe eines Spülmediums weitestgehend von Metallrückständen aus dem Elektrolyten befreit werden kann und eine Rückführungsleitung, über die metallhaltiges Spülmedium aus der Spüleinrichtung in das Beschichtungsbad rücküberführt werden kann.

Die Spüleinrichtung umfasst dabei mindestens zwei, vorzugsweise drei Spülstationen in vorzugsweise kaskadenartiger Anordnung. Die Spülung in den einzelnen Stationen kann beispielsweise mit Träufelrohren, Sprühdüsen, Schwallrohren oder ähnlichem erfolgen. Wichtig ist, dass an der Oberfläche der Substrate eine Konvektion erzeugt wird, damit darauf haftende Metallrückstände aus dem Elektrolyten möglichst vollständig entfernt werden. Bei den Metallrückständen handelt es sich im Übrigen bevorzugt um Metallionen. Die Spülstationen können insbesondere auch wannenförmig und/oder als Durchlauftauchbäder ausgestaltet sein oder entsprechende Wannen und/oder Tauchbäder umfassen.

Bevorzugt umfasst eine erfindungsgemäße Anlage mindestens eine weitere Verdampfungseinrichtung, in der das metallhaltige Spülmedium vor Einspeisung in das Beschichtungsbad eingeengt werden kann. Eine solche Verdampfungseinrichtung weist bevorzugt ein oder mehrere Heizmittel auf, um dem Spülmedium die zur Verdampfung notwendige Energie zuzuführen.

Weiterhin kann die erfindungsgemäße Anlage auch eine oder mehrere Dosiereinrichtungen umfassen, über die dem metallhaltigen Spülmedium ein oder mehrere Metallverbindungen wie Metallsalze und/oder anorganische oder organische Additive zugegeben werden können. Wie bereits erwähnt, wird die Aufkonzentration des Spülmediums bevorzugt derart vorgenommen, dass das Spülmedium auftretende Elektrolytverluste und/oder die durch Abscheidung auf den Substraten verursachten Verluste an Metallionen im Elektrolyten vollständig ausgleicht. Darüber hinaus können auch erforderliche Additive über das Spülmedium in das Beschichtungsbad eingebracht werden.

Weitere Merkmale der Erfindung ergeben sich aus der Zeichnung in Verbindung mit den Unteransprüchen. Hierbei können einzelne Merkmale jeweils für sich oder zu mehreren in Kombination miteinander bei einer Ausführungsform der Erfindung verwirklicht sein. Die beschriebenen bevorzugten Ausführungsformen dienen lediglich zur Erläuterung und zum besseren Verständnis der Erfindung und sind in keiner Weise einschränkend zu verstehen.

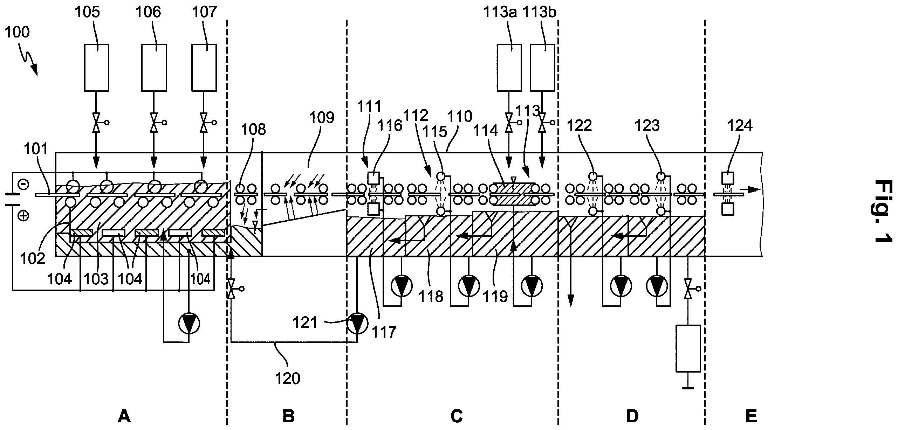

- Fig. 1: zeigt eine schematische Ansicht einer bevorzugten Ausführungsform einer erfindungsgemäßen Metallisierungsanlage.

Die dargestellte erfindungsgemäße Anlage **100** umfasst fünf Stationen A bis E. Über ein Rollentransportsystem werden Wafer **101** durch alle fünf Stationen geführt. In Station A werden die Wafer **101** in ein Beschichtungsbad **102** enthaltend einen Elektrolyten **103** sowie die Elektroden **104** eingetaucht. In diesem Beschichtungsbad wird die Oberfläche der Wafer **101** metallisiert, es wird also eine metallische Ableiterstruktur auf der Oberfläche abgeschieden. Bei dem im Beschichtungsbad **102** enthaltenen Elektrolyten **103** handelt es sich dabei vorzugsweise um einen wässrigen Silberelektrolyten mit einer Konzentration von 5 bis 50 Gramm Silber pro Liter Wasser. Frischer Elektrolyt und Additive können über die Dosiereinrichtungen **105**, **106** und **107** in das Beschichtungsbad **102** eingespeist werden. Die Betriebstemperatur des Elektrolyten **103** liegt in der Regel zwischen 25°C bis 50°C, also leicht über Raumtemperatur. Es treten somit ständig geringe Verluste durch Verdampfung auf. Darüber hinaus wird aber auch Elektrolyt aus dem Bad **102** ausgeschleppt, der an der Oberfläche der Wafer **101** haftet.

Diese werden nach abgeschlossener Beschichtung in die Station B überführt, in der in einem ersten Schritt Elektrolytrückstände auf der Oberfläche der Wafer **101** mechanisch mittels Abquetschwalzen **108** entfernt werden. In einem zweiten Schritt werden die Wafer **101** in einem Luftbad **109** einer Luftabblasung unterzogen. Der dabei abgetrennte Elektrolyt wird in Station A und dort in das Beschichtungsbad **102** rücküberführt.

Derart vorgereinigt werden die Wafer **101** in eine Spüleinrichtung **110** (Station C) überführt. Diese Spüleinrichtung **110** umfasst drei Spülstationen **111**, **112** und **113**, in denen die Wafer **101** nacheinander mit einer säurehaltigen wässrigen Lösung als Spülmedium zur Entfernung von Metallrückständen aus dem Elektrolyten in Kontakt gebracht werden. Dies erfolgt in Station **113** durch Eintauchen der Wafer **101** in ein mit dem Spülmedium gefülltes Tauchbecken **114**, in Station **112** durch Besprühen mit den Sprühdüsen **115** und in Station **111** durch Beträufeln mittels der Träufelrohre **116.** Die drei Spülstationen **111, 112** und **113** umfassen jeweils ein Sammelbecken **117**, **118** und **119** für das Spülmedium, diese sind dabei kaskadenartig angeordnet. Frisches Spülmedium wird lediglich in die Spülstation **113** eingeleitet (aus den Dosiereinrichtungen **113a** und **113b**). Gebrauchtes Spülmedium wird aus dem Sammelbecken **119** in das Sammelbecken **118** überführt und aus diesem den Sprühdüsen **115** zugeführt. Aus dem Sammelbecken **118** wird das Spülwasser weiter in das Sammelbecken **117** geleitet, von wo aus es zum Beträufeln der Wafer **101** verwendet wird. Im Ergebnis ist das Spülmedium im Sammelbecken **119** nahezu metallfrei, während das Spülmedium im Sammelbecken **117** einen vergleichsweise hohen Anteil an Metallrückständen aus dem Elektrolyten aufweist.

Aus dem Sammelbecken **117** erfolgt schließlich ein Transfer des metallhaltigen Spülmediums über die Rückführungsleitung **120** und die Pumpe **121** in Station A. Gegebenenfalls wird das metallhaltige Spülmedium, bevor es in das Beschichtungsbad **102** eingespeist wird, aufkonzentriert.

Die Rückführung des metallhaltigen Spülmediums aus dem Sammelbecken 117 erfolgt nicht unmittelbar über die Rückführungsleitung **120** sondern auf dem Umweg über die Abblaszone bzw. das Luftbad 109. Das verbrauchte Spülmedium kann in der Abblaszone versprüht werden und dampft dabei ein. Diese besonders vorteilhafte Verfahrensvariante erlaubt die Aufkonzentration von Elektrolyten im Spülwasser ohne Installation zusätzlicher Heizeinrichtungen.

Nachdem die Wafer **101** Station C durchlaufen haben, erfolgt in Station D ein abschließender Spülgang mit vollentsalztem Wasser. Aus Station C gegebenenfalls ausgeschlepptes säurehaltiges Spülmedium wird dabei vollständig entfernt. Hierzu sind in Station D die Sprühvorrichtungen **122** und **123** angeordnet. Danach werden die Wafer in Station E im Luftbad **124** getrocknet und anschließend ihrer weiteren Bestimmung zugeführt.

## Patentansprüche

1. Verfahren zur Herstellung metallisierter Halbleitersubstrate mit den Schritten
- Eintauchen eines Halbleitersubstrats in ein einen Elektrolyten enthaltendes Beschichtungsbad,
- Vorzugsweise lichtinduziertes oder lichtunterstütztes Beschichten der Oberfläche des eingetauchten Halbleitersubstrats und
- Überführen des Halbleitersubstrats in eine Spüleinrichtung, in der die beschichtete Oberfläche mit Hilfe eines flüssigen Spülmediums weitestgehend von Metallrückständen aus dem Elektrolyten befreit wird,
wobei das Halbleitersubstrat in der Spüleinrichtung einer Kaskadenspülung unterzogen wird und metallhaltiges Spülmedium aus der Spüleinrichtung in das Beschichtungsbad überführt wird und dort aus dem Bad ausgetragenen und/oder verdampften Elektrolyten zumindest teilweise ersetzt und wobei die Überführung des metallhaltigen Spülmediums aus der Spüleinrichtung nicht unmittelbar zurück in das Beschichtungsbad, sondern auf dem Umweg über eine Abblaszone erfolgt, in der das Spülmedium versprüht wird und dabei eindampft.

2. Verfahren nach Anspruch 1, **dadurch gekennzeichnet, dass** in der Spüleinrichtung anfallendes metallhaltiges Spülmedium vollständig oder teilweise in das Beschichtungsbad überführt wird.

3. Verfahren nach Anspruch 1 oder Anspruch 2, **dadurch gekennzeichnet, dass** das metallhaltige Spülmedium vor Einleitung in das Beschichtungsbad aufkonzentriert wird.

4. Verfahren nach Anspruch 3, **dadurch gekennzeichnet, dass** das metallhaltige Spülmedium durch Verdampfung eingeengt und/oder dem metallhaltigen Spülmedium eine oder mehrere Metallverbindungen zugegeben werden.

5. Verfahren nach einem der vorhergehenden Ansprüche, **dadurch gekennzeichnet, dass** dem Spülmedium Additive, vorzugsweise organische Additive, zugesetzt werden, bevor es in das Beschichtungsbad eingespeist wird.

6. Verfahren nach einem der vorhergehenden Ansprüche, **dadurch gekennzeichnet, dass** ein Spülmedium verwendet wird, das bereits Additive, vorzugsweise organische Additive, enthält.

7. Verfahren nach einem der vorhergehenden Ansprüche, **dadurch gekennzeichnet, dass** Elektrolytrückstände auf der Oberfläche des Halbleitersubstrats vor dessen Überführung in die Spüleinrichtung mechanisch entfernt werden.

8. Verfahren nach einem der vorhergehenden Ansprüche, **dadurch gekennzeichnet, dass** Elektrolytrückstände auf der Oberfläche des Halbleitersubstrats vor dessen Überführung in die Spüleinrichtung mit Druckluft entfernt werden.

9. Anlage zur Herstellung metallisierter Halbleitersubstrate , insbesondere zur Durchführung eines Verfahrens nach einem der vorhergehenden Ansprüche, umfassend
- ein Beschichtungsbad mit einem Elektrolyten zum vorzugsweise lichtinduzierten oder lichtunterstützten Beschichten der Oberfläche eines in das Bad eingetauchten Halbleitersubstrats,
- eine Spüleinrichtung, in der die beschichtete Oberfläche des Halbleitersubstrats mit Hilfe eines Spülmediums weitestgehend von Metallrückständen aus dem Elektrolyten befreit werden kann, wobei die Spüleinrichtung mindestens zwei, insbesondere drei Spülstationen in vorzugsweise kaskadenartiger Anordnung umfasst, und
- eine Rückführungsleitung, über die metallhaltiges Spülmedium aus der Spüleinrichtung in das Beschichtungsbad überführt werden kann und
- eine Abblaszone, in der das Spülmedium versprüht wird und dabei eindampft, bevor es in das Beschichtungsbad überführt wird.

10. Anlage nach Anspruch 9, **dadurch gekennzeichnet, dass** sie mindestens eine weitere Verdampfungseinrichtung umfasst, in der das metallhaltige Spülmedium vor Einspeisung in das Beschichtungsbad eingeengt werden kann, wobei die weitere Verdampfungseinrichtung ein oder mehrere Heizmittel aufweist.

11. Anlage nach einem der Ansprüche 9 oder 10, **dadurch gekennzeichnet, dass** sie mindestens eine Dosiereinrichtung umfasst, über die dem metallhaltigen Spülmedium ein oder mehrere Metallverbindungen und/oder Additive, vorzugsweise organische Additive, zugegeben werden können.

## Claims

1. Method for producing metallized semiconductor substrates, comprising the steps:
- immersion of a semiconductor substrate in a coating bath containing an electrolyte,
- preferably light-induced or light-assisted coating of the surface of the immersed semiconductor substrate, and
- transfer of the semiconductor substrate into a rinsing device, in which metal residues from the electrolyte are as far as possible removed from the coated surface with the aid of a liquid rinsing medium,
wherein the semiconductor substrate is subjected to cascade rinsing in the rinsing device and metal-containing rinsing medium from the rinsing device is transferred into the coating bath and therein is discharged from the bath and/or replaces evaporated electrolyte at least partially, and wherein the transfer of the metal-containing rinsing medium from the rinsing device is not directly back into the coating bath, but on a detour via a blowing zone, wherein the rinsing medium is sprayed and thereby evaporates.

2. Method according to claim 1, **characterized in that** metal-containing rinsing medium accumulated in the rinsing device is completely or partially transferred into the coating bath.

3. Method according to claim 1 or claim 2, **characterized in that** the metal-containing rinsing medium is concentrated before introduction into the coating bath.

4. Method according to claim 3, **characterized in that** the metal-containing rinsing medium is concentrated by evaporation and/or one or more metal compounds are added to the metal-containing rinsing medium.

5. Method according to any of the preceding claims, **characterized in that** additives, preferably organic additives, are added to the rinsing medium before it is fed into the coating bath.

6. Method according to any of the preceding claims, **characterized in that** a rinsing medium which already contains additives, preferably organic additives, is used.

7. Method according to any of the preceding claims, **characterized in that** electrolyte residues on the surface of the semiconductor substrate are mechanically removed before the substrate is transferred into the rinsing device.

8. Method according to any of the preceding claims, **characterized in that** electrolyte residues on the surface of the semiconductor substrate are removed by compressed air before the substrate is transferred into the rinsing device.

9. Installation for producing metallized semiconductor substrates, in particular for carrying out a method according to any of the preceding claims, comprising:
- a coating bath containing an electrolyte for preferably light-induced or light-assisted coating of the surface of a semiconductor substrate immersed in the bath,
- a rinsing device, in which metal residues from the electrolyte can as far as possible be removed from the coated surface of the semiconductor substrate with the aid of a rinsing medium, the rinsing device comprising at least two, in particular three, rinsing stations preferably in a cascade arrangement, and
- a recycling line, through which metal-containing rinsing medium from the rinsing device can be transferred into the coating bath, and
- a blowing zone, in which the rinsing medium is sprayed and thereby evaporates, before it is transferred into the coating bath.

10. Installation according to claim 9, **characterized in that** it comprises at least one further evaporation device, in which the metal-containing rinsing medium can be concentrated before being fed into the coating bath, wherein the further evaporation device includes one or more heating means.

11. Installation according to any of claims 9 or 10, **characterized in that** it comprises at least one dosing device, by means of which one or more metal compounds and/or additives, preferably organic additives, can be added to the metal-containing rinsing medium.

## Revendications

1. Procédé pour produire des substrats semi-conducteurs métallisés, comprenant les étapes:
- immersion d'un substrat semi-conducteur dans un bain de revêtement contenant un électrolyte,
- revêtement de préférence induit par irradiation ou assisté par irradiation de la surface du substrat semi-conducteur immergé et
- transfert du substrat semi-conducteur dans un dispositif de rinçage, dans lequel la surface revêtue est débarrassée de résidus métalliques de l'électrolyte très largement au moyen d'un médium de rinçage liquide,
dans lequel le substrat semi-conducteur subit un rinçage en cascade dans le dispositif de rinçage et médium de rinçage contenant du métal est transféré du dispositif de rinçage au bain de revêtement et y remplace, au moins partiellement, de l'électrolyte déchargé et/ou évaporé du bain, et dans lequel le transfert du médium de rinçage contenant du métal du dispositif de rinçage ne se fait pas directement en retour vers le bain de revêtement, mais au détour via une zone de soufflage où le médium de rinçage est atomisé, tout en évaporant.

2. Procédé selon la revendication 1, **caractérisé en ce que** du médium de rinçage contenant du métal accumulant dans le dispositif de rinçage est transféré complètement ou partiellement au bain de revêtement.

3. Procédé selon la revendication 1 ou la revendication 2, **caractérisé en ce que** le médium de rinçage contenant du métal est concentré avant l'introduction dans le bain de revêtement.

4. Procédé selon la revendication 3, **caractérisé en ce que** le médium de rinçage contenant du métal est concentré par évaporation et/ou un ou plusieurs composés métalliques sont ajoutés au médium de rinçage contenant du métal.

5. Procédé selon l'une quelconque des revendications précédentes, **caractérisé en ce que** des additifs, de préférence additifs organiques, sont ajoutés au médium de rinçage avant qu'il soit amené au bain de revêtement.

6. Procédé selon l'une quelconque des revendications précédentes, **caractérisé en ce qu'**un médium de rinçage utilisé comporte déjà des additifs, de préférence des additifs organiques.

7. Procédé selon l'une quelconque des revendications précédentes, **caractérisé en ce que** des résidus d'électrolyte sur la surface du substrat semi-conducteur sont enlevés mécaniquement avant le transfert du substrat au dispositif de rinçage.

8. Procédé selon l'une quelconque des revendications précédentes, **caractérisé en ce que** des résidus d'électrolyte sur la surface du substrat semi-conducteur sont enlevés par air comprimé avant le transfert du substrat au dispositif de rinçage.

9. Installation pour produire des substrats semi-conducteurs métallisés, en particulier pour exécuter un procédé selon l'une quelconque des revendications précédentes, comprenant
- un bain de revêtement avec un électrolyte pour un revêtement de préférence induit par irradiation ou assisté par irradiation de la surface d'un substrat semi-conducteur immergé dans le bain,
- un dispositif de rinçage, dans lequel la surface revêtue du substrat semi-conducteur peut être débarrassée de résidus métalliques de l'électrolyte très largement au moyen d'un médium de rinçage, le dispositif de rinçage comprenant au moins deux, en particulier trois, stations de rinçage, de préférence en cascade, et
- une conduite de recirculation, à travers de laquelle médium de rinçage contenant du métal peut être transféré au bain de revêtement et
- une zone de soufflage, dans laquelle le médium de rinçage est atomisé tout en évaporant, avant son transfert au bain de revêtement.

10. Installation selon la revendication 9, **caractérisée en ce qu'**elle comprend au moins un autre dispositif d'évaporation, dans lequel le médium de rinçage contenant du métal peut être concentré avant son entrée dans le bain de revêtement, l'autre dispositif d'évaporation comprenant un ou plusieurs moyens de chauffage.

11. Installation selon l'une des revendications 9 ou 10, **caractérisée en ce qu'**elle comprend au moins un dispositif de dosage, par moyen duquel un ou plusieurs composés métalliques et/ou additifs, de préférence des additifs organiques, peuvent être ajoutés au médium de rinçage contenant du métal.
